Europäisches Patentamt

European Patent Office

Office européen des brevets

(11) Publication number: **0 668 617 A2**

# EUROPEAN PATENT APPLICATION

(21) Application number: 95102424.9

(51) Int. Cl.6: **H01L 29/74**

(22) Date of filing: **21.02.95**

(30) Priority: **21.02.94 JP 22491/94**
**25.02.94 JP 28311/94**
**30.11.94 JP 296408/94**

(43) Date of publication of application:
**23.08.95 Bulletin 95/34**

(84) Designated Contracting States:
**DE FR GB**

(71) Applicant: **KABUSHIKI KAISHA TOSHIBA**
**72, Horikawa-cho,**
**Saiwai-ku**
**Kawasaki-shi,**
**Kanagawa-ken 210,**
**Tokyo (JP)**

(72) Inventor: **Fujiwara, Takashi c/o Int. Prop. Div.,**
**KK. Toshiba**
**1-1 Shibaura 1-chome,**
**Minato-ku**
**Tokyo 105 (JP)**
Inventor: **Matsuda, Hideo, c/o Int. Prop. Div.,**
**KK.Toshiba**
**1-1 Shibaura 1-chome,**
**Minato-ku**
**Tokyo 105 (JP)**
Inventor: **Hiyoshi, Michiaki, c/o Int.Prop.Div.,**
**KK. Toshiba**
**1-1 Shibaura 1-chome,**
**Minato-ku**
**Tokyo 105 (JP)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **Semiconductor device improved in resistance to breaking due to cosmic rays.**

(57) The specific resistance $\rho$ of a wafer constituting a single pn junction of a pnpn junction of a GTO thyristor ranges from one-seventeenth the rated voltage to one-twelfth the rated voltage. The thickness (W3) of the wafer is set substantially equal to the width of a depletion layer formed at the pn junction such that punch-through occurs close to the rated voltage. Consequently, the resistance to breaking due to cosmic rays can be improved, the probability of occurrence of defects can be reduced to such an extent as to cause no problems, and the thickness of an $n^-$-type base layer can be made smaller than that of a prior art one.

F I G. 3

The present invention relates to a semiconductor device including a power device, such as a diode and a GTO (gate turn-off thyristor), which requires a high withstand voltage of 2.5 kV or more.

In general, the design of a semiconductor device requiring a high withstand voltage in its vertical direction or in the thickness direction of a wafer is determined as follows. First a rated voltage of the semiconductor device is set, and the specific resistance and thickness of a wafer are determined so as to satisfy the rated voltage within the whole range of compensation temperature. Since, generally, the avalanche voltage decreases as the temperature lowers, a withstand voltage in a normal temperature is determined in view of the decrease in the avalanche voltage, and the specific resistance and thickness of a wafer is determined.

More specifically, when a compensation temperature ranges from -40°C to 125°C in a semiconductor device having a rated voltage of, for example, 4.5 kV, the withstand voltage at the temperature of -40°C is lowered about 10% from the withstand voltage at that of 25°C. Since, therefore, the withstand voltage is 5.175 kV (= 4.5 x 1.15) when the compensation temperature is 25°C, it is set at 5.2 kV or higher. The specific resistance $\rho$ of a wafer having a withstand voltage of 5.2 kV at a temperature of 25°C is about 200 $\Omega$cm. The specific resistance of a wafer usually has an error of about ±10%. Therefore, if the lowest specific resistance is set to 200 $\Omega$cm, it ranges from 200 to 240 $\Omega$cm. When the specific resistance is 240 $\Omega$cm, the extension of a depletion layer is maximized. More specifically, when the specific resistance is 240 $\Omega$cm, the avalanche voltage is about 6.0 kV, and the width of the depletion layer extends to about 650 $\mu$m.

The thickness of the wafer is determined by adding a margin according to each device to the width of the depletion layer. Conventionally, the relationship between the specific resistance $\rho$ and rated voltage $V_D$ of the wafer is determined by the following formula (1):

$$V_D/23 \leq \rho \leq V_D/18 \qquad (1)$$

If the rated voltage $V_D$ is set at, e.g., 4500V, the specific resistance $\rho$ of the wafer is: is set at, e.g., 4500V, the specific resistance $\rho$ of the wafer is:

$$4500/23 \leq \rho \leq 4500/18$$
$$196 \leq \rho \leq 250.$$

In a BLT (Blocking Life Test), if a direct voltage continues to be applied to a semiconductor device having a large diameter and a rated voltage of 2.5 kV, the device cannot suddenly sustain its withstand voltage, and is therefore broken.

It is understood that the device is broken because of cosmic rays (neutrons, protons, etc.) entering the depletion layer to locally generate pairs of electrons and holes and cause a power loss. Moreover, it is turned out that there is a high probability of breaking in a wafer having the specific resistance set by the above formula (1).

An object of the present invention is to provide a semiconductor device capable of improving in resistance to breaking due to cosmic rays and reducing in probability of occurrence of defects to such an extent as to cause no problems.

To attain the above object, there is provided a semiconductor device using a wafer, characterized in that the wafer has a specific resistance ranging from one-seventeenth a rated voltage to one-twelfth the rated voltage.

In order to improve the resistance to breaking of a wafer due to cosmic rays, pairs of secondary electrons and holes have to be prevented from being caused by pairs of electrons and holes generated from the cosmic rays. It is effective in preventing the pairs of secondary electrons and holes that the specific resistance of the wafer is increased to fall within a range from one-seventeenth the rated voltage to one-twelfth the rated voltage and the field intensity is decreased in a depletion layer.

If, however, the specific resistance is increased more greatly than required, the thickness of the wafer is increased and as are the power loss and switching loss at a pn junction, with the result that the semiconductor device becomes impractical. According to the present invention, the thickness of the wafer is set substantially equal to the width of the depletion layer at the pn junction such that punch-through occurs close to the rated voltage.

Furthermore, by covering at least the zenith of the semiconductor device with a shielding member, the cosmic rays can be prevented from entering the semiconductor device, thus reducing the failure rate.

This invention can be more fully understood from the following detailed description when taken in conjunction with the accompanying drawings, in which:

FIG. 1 is a graph showing a relationship between specific resistance $\rho$ and rated voltage in a wafer according to a first embodiment of the present invention and a prior art wafer:

FIG. 2 is a graph showing failure rates of the wafers of the present invention and prior art;

FIG. 3 is a view showing a relationship in thickness of wafer between the present invention and prior art;

FIG. 4A is a cross-sectional view of a semiconductor device using a wafer having a prior art specific resistance;

FIG. 4B is a characteristic view of a semiconductor device using a wafer having a prior art specific resistance;

FIG. 5A is a cross-sectional view of a semiconductor device using a wafer having a specific resistance of the present invention;

FIG. 5B is a characteristic view of a semiconductor device using a wafer having a specific resistance of the present invention;

FIG. 6A is a cross-sectional view of a semiconductor device using a wafer having a specific resistance of the present invention;

FIG. 6B is a characteristic view of a semiconductor device using a wafer having a specific resistance of the present invention;

FIG. 7 is a graph showing a relationship between the thickness of an n- base layer and specific resistance $\rho$ in wafers of the present invention and prior art;

FIG. 8 is a view showing a constitution of a wafer according to a second embodiment of the present invention;

FIG. 9 is a graph for explaining the advantage of the second embodiment;

FIG. 10 is a cross-sectional view showing an example of the second embodiment; and

FIG. 11 is a cross-sectional view showing another example of the second embodiment.

Embodiments of the present invention will be described, with reference to the accompanying drawings.

In a first embodiment of the present invention, an n-type wafer is doped with, e.g., phosphorus in advance and its specific resistance $\rho$ is set high. The specific resistance is adjusted by irradiating the wafer with neutrons and specifically set to a range indicated by the following formula:

$$\text{rated voltage}/17 \leq \rho \leq \text{rated voltage}/12 \qquad (2)$$

If the rated voltage is 4500 V, the specific resistance $\rho$ is:

$$265 \leq \rho \leq 375 \ (\Omega cm)$$

The condition of the above formula (2) was obtained by applying the same high voltage to a plurality of wafers having different specific resistances and measuring time required for breaking the wafers. It has been confirmed that a wafer having the specific resistance satisfying the condition is the most resistant to breaking due to cosmic rays.

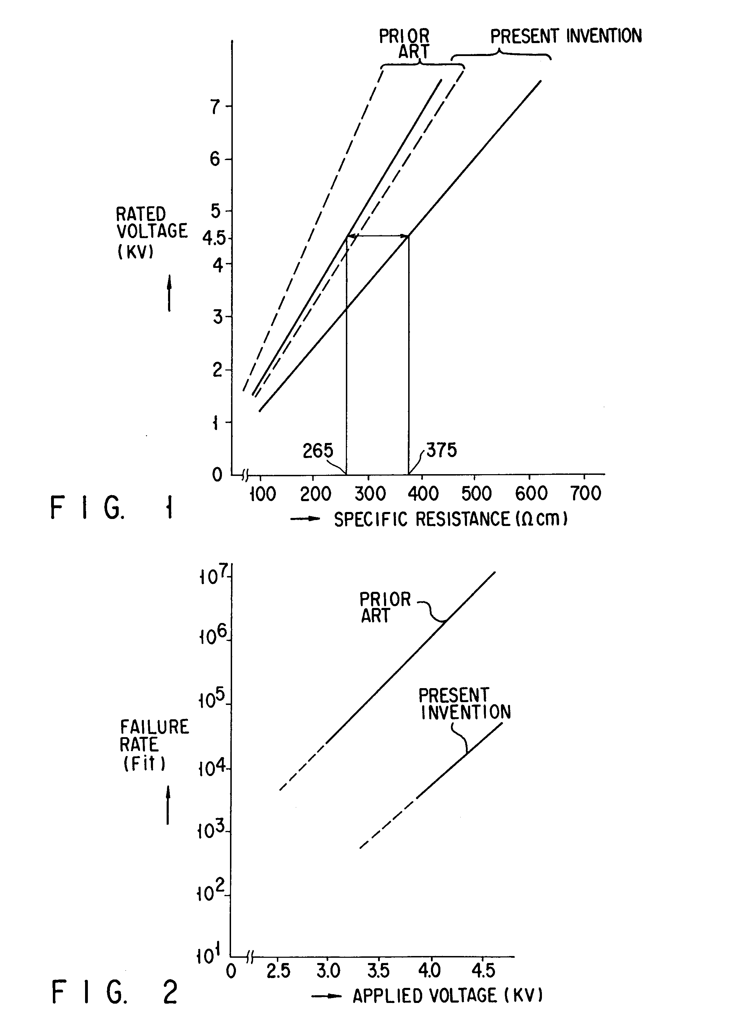

FIG. 1 shows a relationship between specific resistance $\rho$ of a wafer and a rated voltage. In this figure, the solid lines indicate the present invention, whereas the broken lines do the prior art. As is apparent from FIG. 1, the specific resistance of the wafer of the present invention is set higher than that of the prior art wafer at a predetermined rated voltage.

FIG. 2 shows a failure rate of the prior art wafer having a specific resistance satisfying the above formula (1) and that of the wafer of the present invention having a specific resistance satisfying the formula (2), with respect to an applied voltage. The failure rate FR (Fit) is given by the following formula (3):

$$FR = (\text{number of defects/total test time}) \times 10^9 - \qquad (\text{Fit}) \qquad (3)$$

As is apparent from FIG. 2, while the failure rate of the prior art wafer is about $10^7$ Fit at the rated voltage $V_D = 4.5$ kV, that of the wafer of the present invention is about $5 \times 10^4$ Fit at the same rated voltage. Consequently, the failure rate of the present invention is reduced more greatly than that of the prior art.

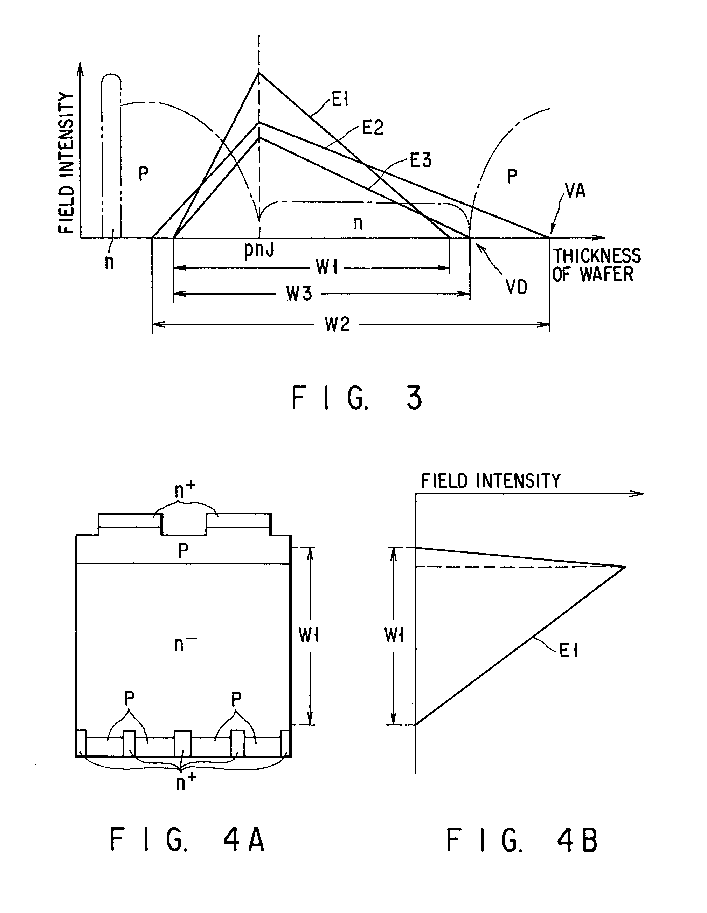

FIG. 3 shows a relationship between the thickness of a wafer (substrate) of a semiconductor device having an npnp junction, such as a reverse conducting GTO thyristor, and the field intensity of a pn junction (pnj) of the device in the prior art and the present invention. FIG. 4 through FIG. 6B specifically show the relationship of FIG. 3.

FIG. 4A shows a GTO thyristor using a wafer having a prior art specific resistance. The GTO thyristor has a peak field intensity at the pn junction thereof, as indicated by E1 in FIGS. 3 and 4B.

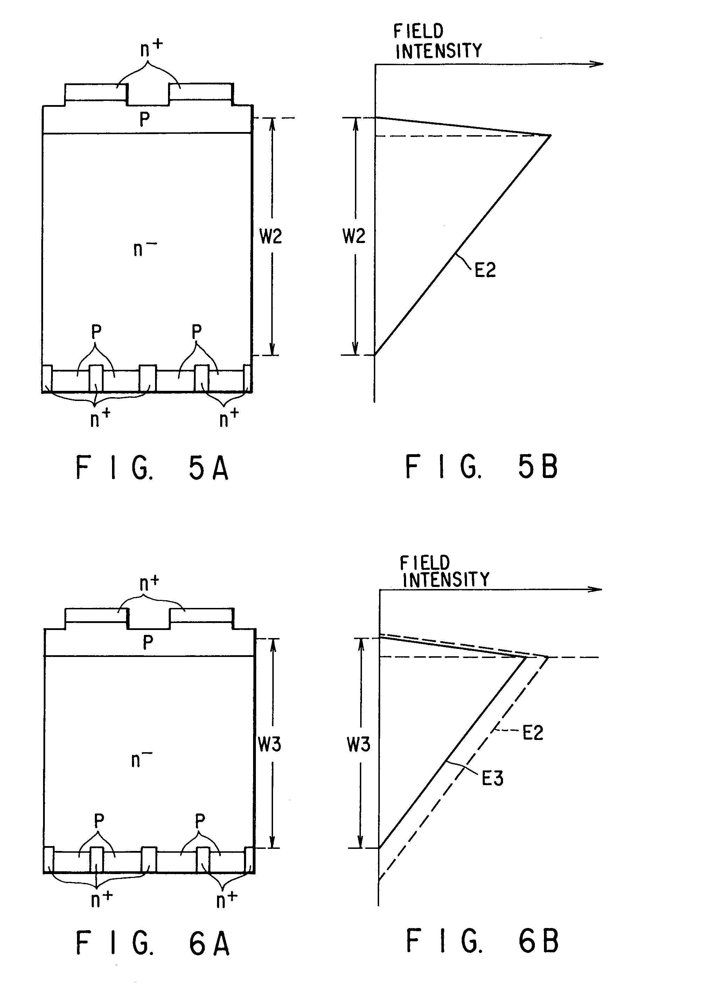

In contrast, FIG. 5A shows a GTO thyristor using a wafer having a specific resistance of the present invention as a substrate. In the thyristor shown in FIG. 5A, a p-type first layer is formed as an anode on the bottom surface of an $n^-$-type substrate. An $n^+$-type region is formed in part of the first layer. A p-type second layer is formed on the surface of the substrate, and an $n^+$-type third layer is formed on the second layer.

The GTO thyristor shown in FIG. 5A also has a peak field intensity at the pn junction thereof as indicated by E2 in FIGS. 3 and 5B. The peak field intensity E2 is lower than that E1 of the prior art GTO thyristor, whereas the thickness W2 of the wafer is larger than the thickness W1 of the prior art wafer as shown in FIGS. 3, 4A and 4B. In other words, the higher the specific resistance, the wider a depletion layer at the pn junction, as in the present invention. The thickness of a wafer is determined with a margin according to each of semiconductor devices. The wafer of the present invention is therefore increased in thickness. As the specific resistance heightens, power loss and switching loss increase.

Consequently, if the withstand voltage of a wafer having a specific resistance of the present invention is not determined by avalanche voltage $V_A$ but rated voltage $V_D$, the wafer can be decreased in thickness.

FIG. 6A shows a GTO thyristor in which the thickness of a wafer is set by the above method. In FIG. 6A, the same elements as those of FIG. 5A are denoted by the same reference numerals. The thickness of the wafer indicated by W3 in FIGS. 3, 6A and 6B is determined as follows. The thickness W3 of a wafer is set substantially equal to the width of a depletion layer formed at the pn junction such that punch-through occurs close to the rated voltage $V_D$. The thickness of the wafer can thus be decreased if a semiconductor device of a punch-through type and, as shown in FIGS. 3 and 6, the peak of field intensity E3 can be made lower than that of field intensity E2, with the result that a semiconductor device having no problems can be attained practically.

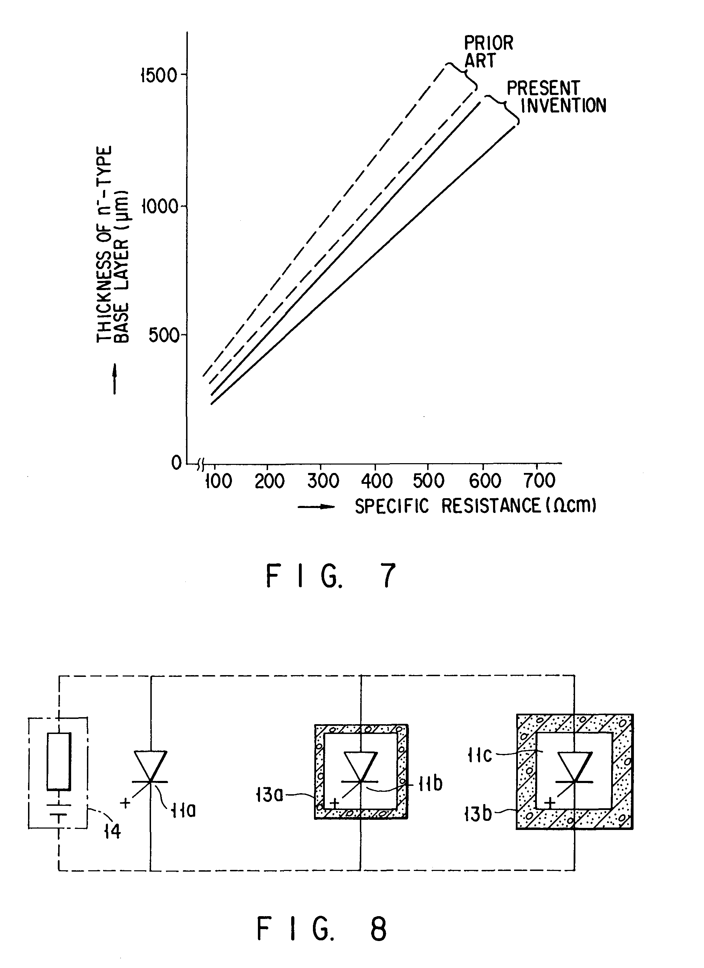

FIG. 7 shows a relationship between the thickness of an n⁻ base layer and specific resistance $\rho$ in the wafer shown in FIG. 6A and the prior art wafer shown in FIG. 4A. As is apparent from this figure, the specific resistance $\rho$ of the present invention is higher than that of the prior art wafer in order to decrease the peak field intensity. Thus the n⁻-type base layer of the present invention can be made thinner than that of the prior art wafer.

A second embodiment of the present invention will now be described, with reference to FIG. 8.

According to the first embodiment, an influence of cosmic rays is eliminated by controlling the specific resistance of a wafer. According to the second embodiment, an influence of cosmic rays is removed by cutting off cosmic rays incident upon a semiconductor device.

The influence of cosmic rays incident upon a semiconductor device can be eliminated by completely cutting off them. It is however difficult to do so since the cosmic rays contain high energy rays of 1 GeV or more. In the second embodiment, therefore, the semiconductor device is shielded from a neutron component of the cosmic rays, which has a great influence (density or dose) thereon.

More specifically, as shown in FIG. 8, a semiconductor device, e.g., GTO thyristors 11b and 11c are shielded from shielding members 13a and 13b. The shielding members 13a and 13b can be formed effectively if their materials are concrete, lead, polyethylene, and the like. To cut off the neutrons of about 10 MeV, the thicknesses of 1/10 value layers of these materials are 53 cm, 103 cm, and 124 cm, respectively, and the most effective material is concrete.

The shielding members 13a and 13b can be formed by a compound material as well as a single material. For example, silicone containing lead is effective as the compound material and its 1/10 value layer has a thickness of 38 cm. The silicone is more effective than concrete. In addition, silicone including gadolinium or boron, and resin materials such as pure polyethylene and epoxy, can be used to absorb thermal neutrons. A water tank including water is also effective in shielding the device from the neutrons. The thickness of each of the shielding members 13a and 13b can be set in accordance with an allowable failure rate of the semiconductor device.

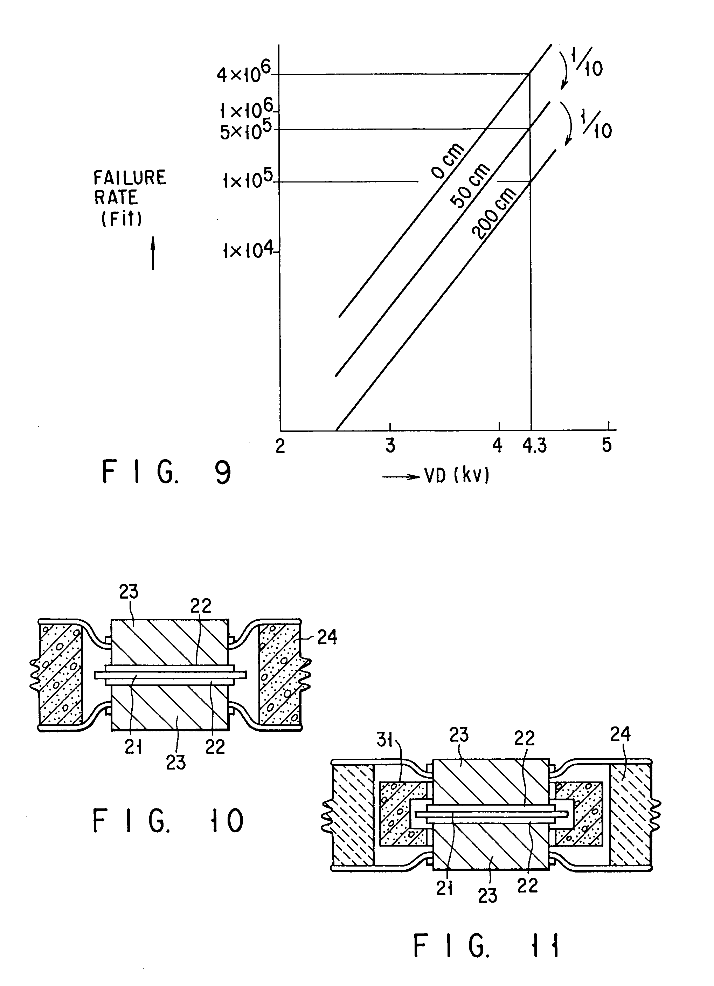

FIG. 9 shows failure rates of GTO thyristors 11b and 11c shielded by the shielding members 13a and 13b of concrete having different thicknesses and shown in FIG. 8 and a GTO thyristor 11a not shielded by any shielding members when a rated voltage of 4.3 kV is applied from a power supply circuit 14 to these thyristors.

In FIG. 9, the failure rate of GTO thyristor 11a which is not shielded by any shielding members, i.e., whose concrete has a thickness of 0 cm is $4 \times 10^6$ Fit, that of GTO thyristor 11b which is shielded by the concrete 13a having a thickness of 50 cm is $5 \times 10^5$ Fit, and that of GTO thyristor 11c which is shielded by the concrete 13b having a thickness of 200 cm is $1 \times 10^5$ Fit.

When the GTO thyristor is shielded by the concrete of 50 cm in thickness, the failure rate is about 1/10 that in the case where the GTO thyristor is not shielded. When the thyristor is shielded by the concrete of 200 cm in thickness, the failure rate is about 1/100 that in the same case.

According to the second embodiment described above, since the cosmic rays coming from the outer space are cut off by shielding a semiconductor device such as a GTO thyristor by shielding members such as concrete, when a high voltage is applied to the semiconductor device to generate an intensive electric field, the number of breaking devices can be decreased, and the rate of failure accidentally caused by incident cosmic rays can greatly be reduced. The shielding members do not have to cover the entire semiconductor device but can be provided at least in the coming direction of the cosmic rays, i.e., in the zenith direction of the semiconductor device.

FIG. 10 is a view specifically showing an example of a semiconductor device having a shielding member. In this example, the shielding member is provided in a GTO thyristor. A disk 22 of molybdenum (Mo) is formed on each side of a silicon pellet 21 to constitute the GTO thyristor, and a columnar electrode 23 of copper (Cu) is disposed on each disk 22. A ring-shaped insulator (envelope) 24, which is formed of concrete or the like, is fixed around them and serves as a shielding member to cut off some of cosmic rays (e.g., neutrons of 100 MeV or less) coming from the outer space.

FIG. 11 is a view showing another example of a semiconductor device having a shielding member. In this example, the insulator 24 is constituted of ceramic. A shielding member 31 of, e.g., concrete is arranged around the pellet 21 and disk 22 inside the insulator 24. Since a shielding member 31 is provided in addition to the insulator 24, some of cosmic rays coming from the outer space can be cut off.

In the examples shown in FIGS. 10 and 11, the thickness of the shielding member can be set in accordance with the allowable failure rate of the GTO thyristor. If, furthermore, a GTO thyristor manufactured by using the wafer of the first embodiment is shielded by the shielding member shown in FIG. 11, the influence of cosmic rays can be eliminated further.

## Claims

1. A semiconductor device using a wafer having a pn junction,
   characterized in that said wafer has a specific resistance ranging from one-seventeenth a rated voltage to one-twelfth the rated voltage.

2. The semiconductor device according to claim 1, characterized in that said wafer has a thickness which is set substantially equal to a width of a depletion layer formed at the pn junction such that punch-through occurs close to the rated voltage.

3. A semiconductor device having an n-type substrate, a p-type first layer formed on one surface of said n-type substrate, a p-type second layer formed on another surface of said n-type substrate, and an n-type third layer formed on said p-type second layer,
   characterized in that said n-type substrate has a specific resistance ranging from one-seventeenth a rated voltage to one-twelfth the rated voltage, and said n-type substrate has a thickness which is set substantially equal to a width of a depletion layer formed at a pn junction such that punch-through occurs close to the rated voltage.

4. The semiconductor device according to claim 3, characterized by comprising a shielding member provided at least in a zenith direction of said semiconductor device, for shielding said semiconductor device from incident cosmic rays.

5. The semiconductor device according to claim 4, characterized in that said semiconductor device is Circular, and said shielding member is provided along a circumference of said semiconductor device.

6. The semiconductor device according to claim 5, characterized in that said shielding member is formed of concrete.

7. The semiconductor device according to claim 5, characterized in that said shielding member is formed of silicone including one of lead, gadolinium, and boron.

8. The semiconductor device according to claim 5, characterized in that said shielding member is formed of pure polyethylene.

9. The semiconductor device according to claim 5, characterized in that said shielding member is formed of epoxy resin.

10. The semiconductor device according to claim 5, characterized in that said semiconductor device constitutes a GTO thyristor.

PRIOR ART    PRESENT INVENTION

RATED
VOLTAGE
(KV)

7

6

5

4.5

4

3

2

1

0

265    375

F I G.   1    ← SPECIFIC RESISTANCE (Ω cm)

100   200   300   400   500   600   700

$10^7$

$10^6$

$10^5$

$10^4$

$10^3$

$10^2$

$10^1$

PRIOR
ART

PRESENT
INVENTION

FAILURE
RATE
(Fit)

F I G.   2    ← APPLIED VOLTAGE (KV)

0   2.5   3.0   3.5   4.0   4.5

F I G. 3

F I G. 4 A

F I G. 4 B

FIG. 5A

FIG. 5B

FIG. 6A

FIG. 6B

F I G. 7

F I G. 8

FAILURE
RATE
(Fit)

FIG. 9

FIG. 10

FIG. 11